Europäisches Patentamt

European Patent Office

Office européen des brevets

(11) Veröffentlichungsnummer: **0 156 981**
**B1**

(12) # EUROPÄISCHE PATENTSCHRIFT

(45) Veröffentlichungstag der Patentschrift:
**09.03.88**

(51) Int. Cl.⁴: **G 01 R 11/04**

(21) Anmeldenummer: **84115141.8**

(22) Anmeldetag: **11.12.84**

(54) Zusatzgerät für einen Elektrizitätszähler.

(30) Priorität: **16.03.84 DE 3409762**

(43) Veröffentlichungstag der Anmeldung:
**09.10.85 Patentblatt 85/41**

(45) Bekanntmachung des Hinweises auf die Patenterteilung:
**09.03.88 Patentblatt 88/10**

(84) Benannte Vertragsstaaten:
**AT CH DE FR GB IT LI**

(56) Entgegenhaltungen:
**CH - A - 585 409**
**DE - A - 1 913 285**
**DE - A - 2 630 608**
**DE - A - 2 712 918**

(73) Patentinhaber: **Siemens Aktiengesellschaft Berlin und München, Wittelsbacherplatz 2, D-8000 München 2 (DE)**

(72) Erfinder: **Greppmaier, Paul, Salzburger Strasse 18, D-8500 Nürnberg (DE)**
Erfinder: **Lang, Walter, Karl-Plesch-Strasse 40, D-8501 Schwanstetten (DE)**
Erfinder: **Schmidt, Gerhard, Tilman-Riemenschneider-Strasse 7, D-8501 Heroldsberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein Zusatzgerät für einen Elektrizitätszähler, wobei das Gehäuse des Zusatzgeräts mindestens zweiteilig mit einem Sockel und einem Oberteil ausgeführt ist, wobei zwischen dem Elektrizitätszähler und Elementen des Zusatzgerätes Steckverbindungen vorgesehen sind.

Zum Zwecke der platzsparenden Befestigung von Zusatzgeräten an einem Elektrizitätszähler werden diese häufig auf einem Befestigungsbügel montiert, der zusammen mit den beiden unteren Zählerbefestigungsfüssen verschraubt wird. Eine derartige Anordnung ist beispielsweise aus dem DE-GM 1 822 173 bekannt. Zur elektrischen Verbindung zwischen Zusatzgerät und Zähler werden vor Montage des Zusatzgeräts die entsprechenden Leiter an den Zählerklemmen angeklemmt. Das Zusatzgerät weist eine Klemmleiste auf, an die dann bei montiertem Zusatzgerät die entsprechenden Leiter angeschlossen werden. Bei einer derartigen Anordnung kann jedoch die Montage und der Austausch des Zusatzgerätes nur durch geschultes Fachpersonal vorgenommen werden, das mit den notwendigen Verdrahtungsarbeiten vertraut ist.

Ein vereinfachter Austausch des Zusatzgeräts ist mit einer Anordnung nach der DE-PS 889 190 möglich. Dabei weist das Zusatzgerät Steckstifte auf, die in entsprechende Steckbuchsen an den Zählerklemmen eingeführt werden. Derartige Zusatzgeräte können jedoch nur auf speziell dafür vorgesehene Zähler montiert werden, so dass der Einsatzbereich stark eingeschränkt ist. Insbesondere können Zähler nicht mit Steckbuchsen für sämtliche möglichen Zusatzgeräte, wie Maximumzähler, Schaltuhren, Rundsteuerempfänger usw. ausgerüstet werden.

Aufgabe der Erfindung ist es daher, ein Zusatzgerät für einen Elektrizitätszähler der eingangs genannten Art so auszugestalten, dass Montage und Austausch des Zusatzgerätes vereinfacht werden, wobei ein Einsatz auch für nicht speziell dafür ausgerüstete Zähler möglich sein soll.

Diese Aufgabe wird erfindungsgemäss dadurch gelöst, dass der Sockel eine Klemmleiste zur elektrischen Verbindung mit dem Elektrizitätszähler und gegebenenfalls mit anderen Geräten und eine damit elektrisch verbundene Buchsenleiste aufweist und dass das Oberteil alle Baugruppen des Zusatzgerätes sowie eine Steckerleiste zur Verbindung dieser Baugruppen mit dem Elektrizitätszähler enthält, die bei aufgesetztem Oberteil in die Buchsenleiste eingeführt ist. Dabei kann nach Aufsetzen des Sockels die komplette Verdrahtung zum Zähler durchgeführt werden. Diese Arbeit muss von geschultem Fachpersonal durchgeführt werden. Die Zahl der Klemmen der Klemmleiste kann dabei so gross gewählt werden, dass eine eindeutige Zuordnung der am Zähler abgegriffenen Signale zu den Klemmen möglich ist. Die Verbindung zum eigentlichen Zusatzgerät erfolgt dann durch Stecken, so dass die Montage und vor allem der Austausch des Zusatzgeräts auch durch weniger ausgebildetes Personal durchgeführt werden kann. Bei einem turnusmässigen Austausch oder bei einem Austausch bei Defekt sind keinerlei Verdrahtungsarbeiten erforderlich, so dass auch Verdrahtungsfehler ausgeschlossen sind. Das erfindungsgemässe Gehäuse erlaubt einen Einsatz bei jedem beliebigen Normzähler, der nicht speziell ausgerüstet sein muss. Auch eine vom Zähler räumlich getrennte Anordnung des Zusatzgerätes ist ohne weiteres möglich.

Eine fertigungstechnisch besonders einfache und raumsparende Ausführung des Gehäuses erreicht man, wenn Klemmleiste und Buchsenleiste an einer in den Sockel eingelegten ersten Leiterplatte befestigt und über diese elektrisch verbunden sind.

Vorteilhafterweise ist die Steckerleiste an einer in Steckrichtung angeordneten zweiten Leiterplatte angebracht, wobei die zweite Leiterplatte im Oberteil mit Spiel gehalten ist und wobei Mittel zur Lagejustierung des Oberteils bezüglich des Sockels und gesonderte Mittel zur Lagejustierung der Steckerleiste bezüglich der Buchsenleiste vorgesehen sind. Damit werden Toleranzprobleme auf einfache Weise gelöst. Die Steckerleiste muss im Oberteil nicht exakt justiert sein. Die erforderliche genaue Lagejustierung der Steckerleiste bezüglich der Buchsenleiste erfolgt vielmehr durch gesonderte Mittel.

Als Mittel zur Lagejustierung des Oberteils bezüglich des Sockels kann mindestens eine, eine Befestigungsschraube umgebende konische Hülse dienen, wobei die konische Hülse beim Aufsetzen des Oberteils auf den Sockel über ein konusförmiges Gegenstück geschoben wird. Zusätzlich können als weitere Mittel zur Lagejustierung des Oberteils bezüglich des Sockels Wandteile des Oberteils, die den Sockel umgreifen, dienen. Damit wird beim Aufsetzen des Oberteils auf den Sockel eine Vorzentrierung erreicht, die ein problemloses Einführen der Steckerleiste des Oberteils in die Buchsenleiste des Sockels ermöglicht.

Als Mittel zur Lagejustierung der Steckerleiste bezüglich der Buchsenleiste kann im Bereich von einer der beiden Leisten ein Vorsprung vorgesehen sein, der beim Aufsetzen des Oberteils in eine entsprechende Ausnehmung der anderen Leiste eingreift. Damit wird die erforderliche exakte Lagejustierung der Steckerleiste bezüglich der Buchsenleiste erreicht, wobei aufgrund der «schwimmenden» Befestigung der Steckerleiste die Lagejustierung unabhängig vom Oberteil möglich ist.

Die zweite Leiterplatte kann in Längsrichtung an einer der Steckerleiste gegenüberliegenden Gehäusewand abgestützt sein, wobei die zweite Leiterplatte in Querrichtung einerseits durch einen Bolzen gegen eine Gehäusewand und andererseits durch eine dritte, parallel zur Sockelebene liegende dritte Leiterplatte abgestützt ist, wobei die dritte Leiterplatte an ihrem der zweiten Leiterplatte gegenüberliegendem Ende mit dem Oberteil verschraubt ist. Damit wird die erforderliche «schwimmende» Befestigung mit geringem konstruktivem Aufwand bei einfacher Montage erreicht.

Der Sockel ist vorteilhafterweise so ausgeführt, dass er anstelle eines Zählerklemmendeckels an den dafür vorgesehenen Schraubbuchsen des Zählerklemmenblocks befestigt werden kann. Die Befestigung am Zählerklemmenblock kann mittels zweier Laschen erfolgen, die ihrerseits austauschbar am Sockel befestigt sind. Durch Austausch dieser Laschen kann der Sockel an unterschiedliche Klemmendeckel Befestigungsmasse angepasst werden, so dass für unterschiedliche Zählerausführungen ein einheitliches Gehäuse verwendet werden kann.

Das Gehäuse kann so ausgeführt sein, dass es als Ersatz für den Zählerklemmendeckel den Zählerklemmenblock und die Anschlussklemmen für das Zusatzgerät überdeckt. Damit erübrigt sich bei montiertem Zusatzgerät eine zusätzliche Abdeckung und Plombierung.

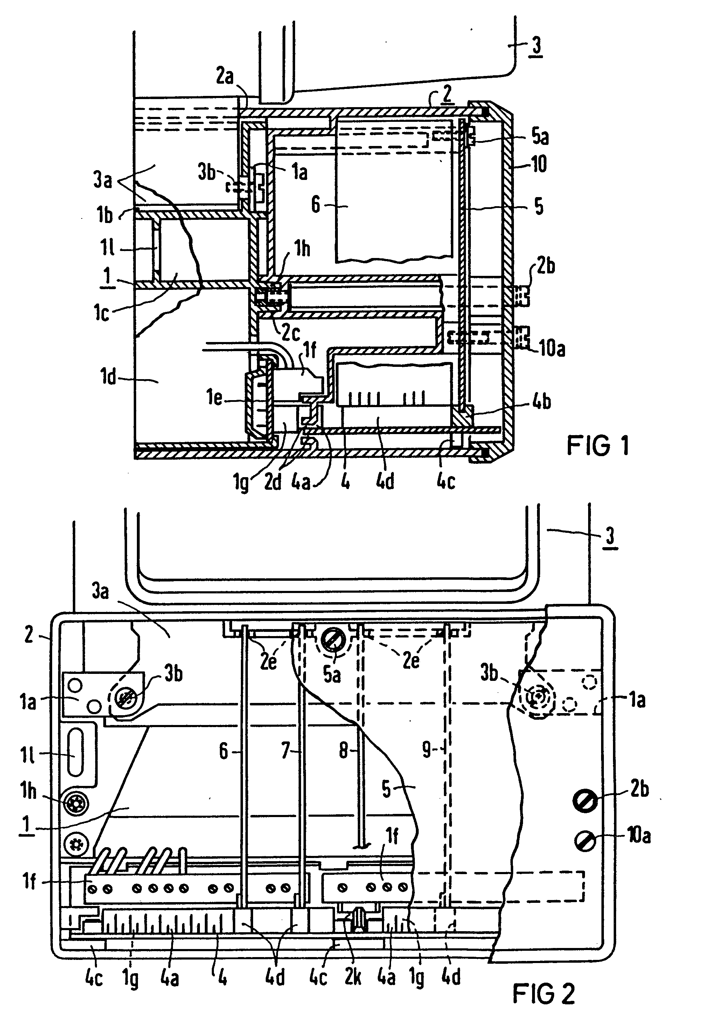

Ein Ausführungsbeispiel der Erfindung wird nachfolgend anhand der Fig. 1 und 2 näher erläutert. Dabei zeigt:

Fig. 1 einen Schnitt durch das Gehäuse in Querrichtung, und

Fig. 2 einen Schnitt in Draufsicht.

Das dargestellte Zusatzgerät ist zur Montage an einem nur schematisch dargestellten Zähler 3 bestimmt. Dieser Zähler 3 weist an seiner Unterseite einen Klemmenblock 3a auf, der beidseitig mit Schraubbuchsen 3b versehen ist. Auf diese Schraubbuchsen 3b wird im Normalfall ein Klemmendeckel aufgeschraubt. Im dargestellten Fall sind jedoch die Schraubbuchsen 3b zur Befestigung des Zusatzgerätes verwendet.

Der Sockel 1 des Gehäuses für das Zusatzgerät ist im wesentlichen kastenförmig ausgebildet. An seiner Oberseite sind lösbar zwei nach innen ragende Laschen 1a befestigt. Diese Laschen weisen im Bereich der Schraubbuchsen 3b des Klemmenblocks 3a jeweils eine Bohrung auf. Mit Hilfe dieser Laschen 1a wird der Sockel 1 mit dem Klemmenblock 3a des Zählers 3 verschraubt. Der Sockel 1 kann jedoch durch die beidseitig vorhandenen Langlöcher 11, auch getrennt vom Zähler an einer Schalttafel befestigt werden. Der Sockel 1 weist zur Unterseite hin drei Leerräume 1b, 1c, 1d auf. Dabei ragt in den Leerraum 1b der Klemmenblock 3a, der Leerraum 1c kann eventuell am Klemmenblock vorhandene Überbrückungsstecker aufnehmen und der Leerraum 1d zusammen mit dem Leerraum 1c ist schliesslich für einen Steckadapter gedacht, der alternativ zu einem direkten Anschluss des Zusatzgeräts an dem Klemmenblock 3a eingesetzt werden kann.

Auf der Oberseite des Sockels 1 ist eine Leiterplatte 1e eingeschnappt. Diese Leiterplatte 1e trägt parallel zueinander eine Klemmleiste 1f und eine Buchsenleiste 1g, die über Leiterbahnen der Leiterplatte 1e elektrisch verbunden sind. Von der Klemmleiste 1f wird eine Verdrahtung zum Klemmenblock 3a des Zählers 3 und eventuell zu anderen Geräten durchgeführt.

Auf diesen Sockel 1 kann ein im folgenden näher beschriebenes Oberteil 2 mit den Bauelementen des Zusatzgeräts aufgesetzt werden. Dieses Oberteil 2 ist ebenfalls im wesentlichen kastenförmig ausgeführt. Der untere Bereich der Aussenwand 2a umgreift den Sockel 1. Das Oberteil ist mit zwei plombierbaren Schrauben 2b am Sockel 1 befestigt. Dazu sind am Sockel 1 zwei konusförmige Vorsprünge 1h vorgesehen, in denen je ein Gewinde für die Befestigungsschrauben 2b angeordnet ist. Das Oberteil 2 weist im Bereich jedes konusförmigen Ansatzes 1h einen Innenkonus 2c auf, der bei montiertem Oberteil 2 über den konusförmigen Ansatz 1h geschoben ist. Das Oberteil 2 wird mit einem Deckel 10 abgeschlossen. Dazu sind zwei plombierbare Befestigungsschrauben 10a vorgesehen.

Im Oberteil 2 sind zwei Leiterplatten 4 und 5 senkrecht zueinander angeordnet. Dabei liegt die Leiterplatte 4 parallel zu einer Gehäusewand im Bereich der Buchsenleiste 1g und weist an ihrer Unterkante eine Steckerleiste 4a auf, die bei aufgesetztem Oberteil 2 in die Buchsenleiste 1g eingeführt ist. Die Leiterplatte 5 liegt parallel zum Deckel des Oberteils 2. Sie ist auf einer Seite über einen Steckverbinder 4b mit der Leiterplatte 4 elektrisch und mechanisch verbunden und auf der anderen Seite mit einer Schraube 5a mit dem Oberteil 2 verschraubt.

Die Leiterplatte 4 stützt sich über Abstandsbolzen 4c an einer Seitenwand des Oberteils 2 und mit einer Kante gegen einen Gehäusedeckel 10 ab. Ferner ist die Leiterplatte 4a in ihrem unteren Bereich durch einen Schlitz 2d des Oberteils 2 geführt. Weitere Befestigungen für die Leiterplatte 4 sind nicht vorgesehen, so dass diese mit erheblichem Spiel im Oberteil 2 gehalten wird.

Die Leiterplatte 4 kann weitere Steckverbinder 4d aufweisen, in die Zusatzleiterplatten 6 bis 9 eingesteckt werden können. Diese stehen senkrecht zu den Leiterplatten 4 und 5 und werden an ihren, den Steckverbindern 4d gegenüberliegenden Enden mit Führungsschlitzen 2e im Oberteil geführt. Die Länge der Zusatzleiterplatten 6–9 entspricht der Gehäusetiefe, so dass sich diese nicht aus ihren Steckverbindungen lösen können. Mit diesen Zusatzleiterplatten 6 bis 9 kann die Packungsdichte an elektronischen Bauteilen erhöht werden. Sie eignen sich aufgrund ihrer leichten Austauschbarkeit besonders zur Aufnahme alternativer Ausbauvarianten des Zusatzgerätes.

Die Buchsenleiste 1g und die Steckerleiste 4a sind zweigeteilt. Zwischen den beiden Teilen ist ein Zentriervorsprung 2k des Oberteils vorgesehen, der die Sockelleiste 4a zentriert und beim Aufsetzen des Oberteils 2 in eine entsprechende Ausnehmung im Bereich der Buchsenleiste 1g eingreift. Damit wird die für den Steckvorgang erforderliche exakte Justierung der Steckerleiste 4a bezüglich der Buchsenleiste 1g erreicht.

Mit dem beschriebenen Gehäuse ist das Zusatzgerät besonders einfach zu montieren. In das Oberteil werden lediglich die beiden zusammengesteckten Leiterplatten 4 und 5, gegebenenfalls zusammen mit den Zusatzleiterplatten 6 bis 9, eingelegt. Zur Befestigung muss dann lediglich die Schraube 5a eingedreht werden. Anschliessend wird mit zwei plombierbaren Befestigungsschrauben 10a der Deckel 10 aufgesetzt. Damit ist eine, bei entsprechender Plombierung gegen äussere Eingriffe geschützte funktionsfähige Einheit aufgebaut, die lediglich am Einbauort noch auf den Sockel 1 aufgesteckt werden, mit den Befestigungsschrauben 2b befestigt und plombiert werden muss.

Die Leiterplatten 4 und 5 werden lediglich durch den Führungsschlitz 2d des Oberteils, durch die Bolzen 4c, durch die Schraube 5a und durch die sich gegen den Deckel 10 abstützende Kante der Leiterplatte 4 fixiert. Dabei weist die Leiterplatte 4 ein erhebliches Spiel auf, so dass an das gesamte Oberteil 2 nur sehr geringe Toleranzanforderungen gestellt werden.

Der Sockel 1 wird unabhängig vom Oberteil 2 am vorgesehenen Einbauort montiert. Die Verdrahtung zwischen der Klemmleiste 1f und dem Zählerklemmenblock 3a muss von entsprechend geschultem Fachpersonal durchgeführt werden. Die Montage des funktionsfähigen Zusatzgeräts auf dem Sockel 1 kann dann von nicht speziell ausgebildetem Hilfspersonal durchgeführt werden. Dabei muss das Oberteil 2 lediglich auf den Sockel 1 aufgesteckt werden. Durch die den Sockel 1 umgreifenden Teile 2a der Aussenwand des Oberteils 2 erfolgt dabei eine Vorjustierung zwischen Sockel 1 und Oberteil 2. Eine exaktere Justierung erfolgt, wenn nachfolgend der Innenkonus 2c über den konusförmigen Ansatz 1h geschoben wird. Auch dabei muss jedoch nicht die für die Steckverbindung erforderliche Justiergenauigkeit erreicht werden. Die im Oberteil 2 schwimmend aufgehängte Steckerleiste 4a zentriert sich nämlich über den Zentrieransatz 1k des Oberteils 2.

Der Zentrieransatz 1k des Oberteils wird zwischen den beiden Teilen der Buchsenleiste 1g geführt, so dass eine für die Steckverbindung Buchsenleiste-Steckerleiste ausreichende Genauigkeit erreicht wird. Durch diese stufenweise Justierung ist ein problemloses Aufstecken des Oberteils 2 auf den Sockel 1 möglich, wobei ausserdem an das Oberteil 2 keine besonderen Toleranzanforderungen gestellt werden. Die Befestigung des Oberteils 2 am Sockel erfolgt schliesslich mit zwei plombierbaren Befestigungsschrauben 2b. Bei aufgesetztem Oberteil 2 sind die Anschlussklemmen des Zählers 3 sowie die Klemmen des Zusatzgeräts abgedeckt. Gesonderte Klemmenabdeckungen und Plombierungen sind daher nicht mehr erforderlich.

Bei vom Zähler getrennter Montage wird der offene Bereich des Klemmenblockausschnitts im Oberteil mit einem Einsatz verschlossen.

Die Vorteile des beschriebenen Zusatzgeräts kommen vor allem dann zur Geltung, wenn aufgrund eines Defekts oder eines turnusmässigen Austausches das Zusatzgerät ausgewechselt werden muss. Das Oberteil 2 kann dann leicht abgezogen und ein neues Gerät aufgesetzt werden, ohne dass die Plombierung des Gerätes entfernt werden muss. Dabei entfällt das Risiko von Verdrahtungsfehlern beim Geräteaustausch.

**Patentansprüche**

1. Zusatzgerät für einen Elektrizitätszähler, wobei das Gehäuse des Zusatzgerätes mindestens zweiteilig mit einem Sockel (1) und einem Oberteil (2) ausgeführt ist, wobei zwischen dem Elektrizitätszähler und den Elementen des Zusatzgerätes Steckverbindungen vorgesehen sind, dadurch gekennzeichnet, dass der Sockel (1) eine Klemmleiste (1f) zur elektrischen Verbindung des Zusatzgerätes mit dem Elektrizitätszähler (3) und gegebenenfalls mit anderen Geräten und eine damit elektrisch verbundene Buchsenleiste (1g) aufweist und dass das Oberteil (2) alle Baugruppen des Zusatzgeräts sowie eine Steckerleiste (4a) zur Verbindung dieser Baugruppe mit dem Elektrizitätszähler (3) enthält, die bei aufgesetztem Oberteil (2) in die Buchsenleiste (1g) eingeführt ist.

2. Zusatzgerät nach Anspruch 1, dadurch gekennzeichnet, dass Klemmleiste (1f) und Buchsenleiste (1g) an einer in den Sockel (1) eingelegten ersten Leiterplatte (1e) befestigt und über diese elektrisch verbunden sind.

3. Zusatzgerät nach Anspruch 1 oder 2, dadurch gekennzeichnet, dass die Steckerleiste (4a) an einer in Steckrichtung angeordneten zweiten Leiterplatte (4) angebracht ist, dass die zweite Leiterplatte (4) im Oberteil (2) mit Spiel gehalten ist, dass Mittel (1h, 2c) zur Lagejustierung des Oberteils (2) bezüglich des Sockels (1) und gesonderte Mittel (2k) zur Lagejustierung der Steckerleiste (4a) bezüglich der Buchsenleiste (1g) vorgesehen sind.

4. Zusatzgerät nach Anspruch 3, dadurch gekennzeichnet, dass als Mittel zur Lagejustierung des Oberteils (2) bezüglich des Sockels (1) mindestens eine eine Befestigungsschraube (2b) umgebende konische Hülse (2c) dient, wobei die konische Hülse (2c) beim Aufsetzen des Oberteils (2) auf den Sockel (1) über ein konusförmiges Gegenstück (1h) geschoben wird.

5. Zusatzgerät nach Anspruch 4, dadurch gekennzeichnet, dass als weitere Mittel zur Lagejustierung des Oberteils (2) bezüglich des Sockels (1) Wandteile (2a) des Oberteils (2), die den Sockel (1) umgreifen, dienen.

6. Zusatzgerät nach einem der Ansprüche 3 bis 5, dadurch gekennzeichnet, dass als Mittel zur Lagejustierung der Steckerleiste (4a) bezüglich der Buchsenleiste (1g) im Bereich von einer der beiden Leisten (1g) ein Vorsprung (2k) vorgesehen ist, der beim Aufsetzen des Oberteils (2) in eine entsprechende Ausnehmung der anderen Leiste (4a) eingreift.

7. Zusatzgerät nach einem der Ansprüche 3 bis 6, dadurch gekennzeichnet, dass die zweite Leiterplatte (4) in Längsrichtung an einer der Steckerleiste (4a) gegenüberliegenden Gehäusewand (10) abgestützt ist, und dass die zweite Leiterplatte (4) in Querrichtung einerseits durch einen Bolzen (4c) gegen eine Gehäusewand und andererseits durch eine dritte, parallel zur Sockelebene liegende dritte Leiterplatte (5) abgestützt ist, wobei die dritte Leiterplatte (5) an ihrem der zweiten Leiterplatte (4) gegenüberliegenden Ende mit dem Oberteil (2) verschraubt ist.

8. Zusatzgerät nach einem der Ansprüche 1 bis 7, dadurch gekennzeichnet, dass der Sockel (1) so ausgeführt ist, dass er anstelle eines Zählerklemmendeckels an dafür vorgesehenen Schraubbuchsen (3b) eines Zählerklemmenblocks (3a) befestigt werden kann.

## Claims

1. An auxiliary device for an electricity meter, where the housing of the auxiliary device consists of at least two parts, a base (1) and an upper part (2), plug-and-socket connections being provided between the electricity meter and elements of the auxiliary device, characterized in that the base (1) is provided with a connecting strip (1f) which electrically connects the auxiliary device to the electricity meter (3) and, where appropriate, to other devices, and with a socket strip (1g) electrically connected thereto; and that the upper part (2) contains all the assemblies of the auxiliary device and a plug strip (4a) for connecting these assemblies to the electricity meter (3) and which is inserted into the socket strip (1g) when the upper part (2) is placed in position.

2. An auxiliary device as claimed in claim 1, characterized in that the connecting strip (1f) and socket strip (1g) are secured to a first circuit board (1e) which is inserted into the base (1) and are electrically connected by way of said circuit board.

3. An auxiliary device as claimed in claim 1 or 2, characterized in that the plug strip (4a) is arranged on a second circuit board (4) extending in the plug-in direction; that the second circuit board (4) is mounted with play in the upper part (2); that means (1h, 2c) are provided for adjusting the position of the upper part (2) relative to the base (1); and that separate means (2k) are provided for adjusting the position of the plug strip (4a) relative to the socket strip (1g).

4. An auxiliary device as claimed in claim 3, characterised in that the means which adjust the position of the upper part (2) relative to the base (1) consists of at least one conical sleeve (2c) which surrounds a fixing screw (2b), the conical sleeve (2c) being moved over a conical counter-member (1h) when the upper part (2) is placed on the base (1).

5. An auxiliary device as claimed in claim 4, characterized in that the further means which adjusts the position of the upper part (2) relative to the base (1) is formed by wall parts (2a) of the upper component (2) which grip round the base (1).

6. An auxiliary device as claimed in one of claims 3 to 5, characterized in that the means which adjust the position of the plug strip (4a) relative to the socket strip (1g) is formed by a projection (2k) which is provided in the region of one of the two strips (1g) and which engages into a corresponding recess in the other strip (4a) when the upper part (2) is placed in position.

7. An auxiliary device as claimed in one of claims 3 to 6, characterized in that in its longitudinal direction, the second circuit board (4) rests against a wall (10) of the housing which is arranged opposite the plug strip (4a); and that in the transverse direction the second circuit board (4) is supported, on the one hand, by a pin (4c) against a wall of the housing and, on the other hand, by a third circuit board (5) which is arranged parallel to the plane of the base, the third circuit board (5) being screwed to the upper part (2) at its end facing the second circuit board (4).

8. An auxiliary device as claimed in one of claims 1 to 7, characterized in that the base (1) is so designed that it can be fastened to threaded bushings (3b), provided for this purpose, of a meter terminal box (3a), in place of a meter terminal cover.

9. An auxiliary device as claimed in claim 8, characterized in that the attachment to the meter terminal box (3a) is effected by means of two lugs (1a) which are themselves exchangeably fastened to the base (1).

10. An auxiliary device as claimed in claim 9, characterized in that as a substitute for the meter terminal cover, it covers the meter terminal box (3a) and the connection terminals for the auxiliary device.

## Revendications

1. Appareil accessoire pour un compteur d'électricité, appareil qui comprend un boîtier en au moins deux parties, un socle (1) et un dessus (2), avec prévision de connexions à enfichage entre le compteur d'électricité et des éléments de l'appareil accessoire, caractérisé en ce que le socle (1) présente une réglette à bornes (1f) pour le raccordement électrique de l'appareil accessoire au compteur d'électricité (3) et, éventuellement à d'autres appareils, de même qu'une réglette à douilles ou connecteur femelle (1g) relié électriquement à la réglette à bornes, et que le dessus (2) contient tous les sous-ensembles de l'appareil accessoire et une réglette à broches ou connecteur mâle (4a) destiné à la connexion de ces sous-ensembles au compteur d'électricité (3) et qui est introduit dans le connecteur femelle (1g) lorsque le dessus (2) est mis en place sur le socle.

2. Appareil selon la revendication 1, caractérisé en ce que la réglette à bornes (1f) et le connecteur femelle (1g) sont fixés à une première plaque à circuits imprimés (1e) disposée dans le socle (1) et sont reliés électriquement à travers cette plaque.

3. Appareil selon la revendication 1 ou 2, caractérisé en ce que le connecteur mâle (4a) est disposé sur une deuxième plaque à circuits imprimés (4), orientée dans la direction d'enfichage, que la deuxième plaque à circuits imprimés (4) est tenue avec jeu dans le dessus (2), que des moyens (1h, 2c) sont prévus pour ajuster la position du dessus (2) par rapport au socle (1) et que des moyens particuliers (2k) sont prévus pour ajuster la position du connecteur mâle (4a) par rapport au connecteur femelle (1g).

4. Appareil selon la revendication 3, caractérisé en ce qu'au moins une douille conique (2c), entourant une vis de fixation (2b), sert de moyen pour ajuster la position du dessus (2) par rapport au socle (1), la douille conique (2c) s'emboîtant sur une formation conique antagoniste (1h) à la mise en place du dessus (27 sur le socle (1).

5. Appareil selon la revendication 4, caractérisé en ce que des parties (2a) de la paroi du dessus (2), venant s'emboîter sur le socle (1), servent de moyens supplémentaires pour ajuster la position du dessus (2) par rapport au socle (1).

6. Appareil selon une des revendications 3 à 5, caractérisé par la prévision, en tant que moyen pour ajuster la position du connecteur mâle (4a) par rapport au connecteur femelle (1g), d'une saillie (2k) dans la région d'un (1g) des deux connecteurs, saillie qui pénètre dans un creux correspondant de l'autre connecteur (4a) à la mise en place du dessus (2).

7. Appareil selon une des revendications 3 à 7, caractérisé en ce que la deuxième plaque à circuits imprimés (4) est appuyée en direction longitudinale sur une paroi de boîtier (10) située à l'opposé du connecteur mâle (4a) et que la deuxième plaque à circuits imprimés (4) est appuyée, en direction transversale, d'une part sur une paroi du boîtier, avec interposition d'une cheville (4c), et d'autre part par une troisième plaque à circuits imprimés (5), disposée parallèlement au plan du socle et qui est fixée par vissage sur le dessus (2) par son extrémité située à l'opposé de la deuxième plaque à circuits imprimés (4).

8. Appareil selon une des revendications 1 à 7, caractérisé en ce que le socle (1) est réalisé de manière qu'il puisse être fixé sur un bloc de connexion (3a) du compteur, à la place d'un couvre-bornes du compteur, sur deux douilles taraudées (3b) prévues pour ce dernier sur le bloc de connexion (3a).

9. Appareil selon la revendication 8, caractérisé en ce que la fixation sur le bloc de connexion (3a) du compteur s'effectue au moyen de deux pattes (1a) qui sont elles-mêmes fixées interchangeables sur le socle (1).

10. Appareil selon la revendication 9, caractérisé en ce qu'il recouvre le bloc de connexion (3a) du compteur, à la place du couvre-bornes du compteur, et qu'il recouvre également ses propres bornes de raccordement.

FIG 1

FIG 2